# EUROPÄISCHE PATENTANMELDUNG

(11) **EP 4 734 670 A2**
(43) Veröffentlichungstag der Anmeldung: **29.04.2026**
(21) Anmeldenummer: 25210134.0
(22) Anmeldetag: 21.10.2025
(51) Int. Cl.: H05K 3/00, H05K 1/11, H05K 1/03, H05K 3/28, H05K 1/09, H05K 3/12, F16L 11/127

(54) **KONTAKTIERUNGSMÖGLICHKEIT FÜR EINE IN EINEM MEHRSCHICHTVERBUNDARTIKEL INTEGRIERTE LEITERANORDNUNG**

(30) Priorität: 24.10.2024 DE 102024210286
(71) Anmelder: ContiTech Deutschland GmbH, 30175 Hannover (DE)
(72) Erfinder: Schröder, André, 34346 Hann. Münden (DE); Wolfer, Tim, 30419 Hannover (DE)
(74) Vertreter: Preusser, Andrea

(57) **Zusammenfassung**

Die Erfindung betrifft ein Verfahren (100) zur Herstellung eines Mehrschichtverbundartikels (10) mit darin integrierter Leiteranordnung (20). Es wird vorgeschlagen, unter einer Deckschicht (13) des Mehrschichtverbundartikels (10) ein Laserstrahlung reflektierendes Reflektorelement (30) zu integrieren. Das Reflektorelement (30) definiert auf diese Weise einen Bearbeitungspfad, entlang dem die Deckschicht (13) mittels Laserablation prozesssicher abgetragen werden kann.

## Beschreibung

Die vorliegende Erfindung betrifft ein Verfahren zur Herstellung eines Mehrschichtverbundartikels mit einer darin integrierten Leiteranordnung mit den Merkmalen des Anspruchs 1. Gegenstand der Erfindung ist ebenfalls ein Mehrschichtverbundartikel mit den Merkmalen des Anspruchs 13.

Durch die Integration von Leiteranordnungen in Mehrschichtverbundartikel wie Schläuche, Förderbänder, Riemen und/oder Luftfedern lassen sich diverse vorteilhafte Funktionen sensorischer, signalübertragender und/oder aktuatorischer Art realisieren.

Ein Problem hierbei ist, die elektrische Kontaktierung der in den Schichtverbund eingebetteten Leiteranordnung zum Zwecke der Signalübertragung und/oder zum Zwecke der Energieversorgung. Hierbei muss eine Außenschicht des Schichtverbunds durchbrochen und ein Kontaktierungsbereich der Leiteranordnung freigelegt werden, um anschließend mit einer externen Komponente, z.B. mit einem Kabel oder einem Stecker, elektrisch verbunden zu werden. Beim Durchbrechen der Außenschicht und dem Freilegen des Kontaktierungsbereichs ist darauf zu achten, dass weder die Leiteranordnung noch der übrige Mehrschichtverbundartikel beschädigt werden. Diese komplexen Verfahrensschritte werden daher in der Regel händisch durchgeführt, was aufwendig ist.

Aufgabe der vorliegenden Erfindung ist es, ein Verfahren zur Herstellung einer elektrischen Kontaktierungsmöglichkeit für eine in einem Mehrschichtverbundartikel integrierte Leiteranordnung bereitzustellen, welches die Nachteile des Standes der Technik zumindest teilweise vermindert. Insbesondere soll ein Verfahren bereitgestellt werden, welches sich zumindest teilweise automatisieren lässt.

Diese Aufgabe wird durch Verfahren mit den Merkmalen des Anspruchs 1 gelöst. Bevorzugte Merkmale sind Gegenstand der abhängigen Ansprüche. Weitere Vorteile und Merkmale sind der allgemeinen Beschreibung sowie den Ausführungsbeispielen zu entnehmen. Gegenstand der vorliegenden Erfindung ist auch ein Mehrschichtverbundartikel mit den Merkmalen des Anspruchs 13.

### Das erfindungsgemäße Verfahren zur Herstellung eines

Mehrschichtverbundartikels mit darin integrierter Leiteranordnung, weist folgende Schritte auf:
- Bereitstellen eines Mehrschichtverbundartikels, insbesondere eines Schlauches, eines Förderbands, eines Riemens und/oder einer Luftfeder, enthaltend ein elastomeres Material sowie vorzugsweise einen Festigkeitsträger,
   wobei der Mehrschichtverbundartikel eine Trägerschicht und eine auf der Trägerschicht angeordnete Deckschicht aufweist,
   wobei in einem ersten Bereich des Mehrschichtverbundartikels zwischen einer der Deckschicht zugewandten Außenfläche der Trägerschicht und einer der Trägerschicht abgewandten Außenfläche der Deckschicht eine Leiteranordnung mit einem Kontaktierungsbereich angeordnet ist, wobei der Kontaktierungsbereich ausgebildet ist, mit einer externen Komponente elektrisch verbunden zu werden,
   wobei in einem zweiten Bereich des Mehrschichtverbundartikels zwischen der der Deckschicht zugewandten Außenfläche der Trägerschicht und der der Trägerschicht abgewandten Außenfläche der Deckschicht ein Reflektorelement angeordnet ist; und
- Abtragen der Deckschicht im zweiten Bereich mittels Laserablation von der von der Trägerschicht abgewandten Außenfläche der Deckschicht zumindest bis zu einer der Trägerschicht abgewandten Außenfläche des Reflektorelements.

Der Erfindung liegt die Idee zugrunde, die Deckschicht bzw. Außenschicht des Mehrschichtverbundartikels in kontrollierter Weise mittels Laserablation zu durchbrechen, wobei die Eindringtiefe der Laserstrahlung durch die Position eines in dem Mehrschichtverbundartikel angeordneten, die Laserstrahlung zumindest teilweise reflektierenden Reflektorelements vorbestimmt werden kann. Die in der Regel gepulste Laserstrahlung mit hoher Leistungsdichte kann auf einen eng begrenzten Bereich der Deckschicht fokussiert werden. Das insbesondere ein Elastomer und/oder ein thermoplastisches Elastomer enthaltende Material der Decksicht absorbiert die Laserstrahlung und wird auf diese Weise sublimiert und abgetragen. Das Abtragen der Deckschicht erfolgt so lange, bis ein in oder unter der Deckschicht angeordnetes Reflektorelement durch die Laserstrahlung freigelegt wird, da - im Gegensatz zur Deckschicht - das Reflektorelement die Laserstrahlung vorwiegend reflektiert, so dass das Material des Reflektorelements nicht oder nur in geringem Maße abgetragen wird. Auf diese Weise können die unter dem Reflektorelement liegenden Schichten und/oder Teile des Mehrschichtverbundartikels oder ggf. vorhandener elektronischer Bauteile vor der Sublimation durch die Laserstrahlung abgeschirmt werden. Das kontrollierte Abtragen bzw. Durchbrechen der Deckschicht vereinfacht das Freilegen des Kontaktierungsbereichs der Leiteranordnung die Herstellung einer elektrischen Kontaktierungsmöglichkeit.

Ein Vorteil der Erfindung besteht darin, dass die Laserstrahlung im Grunde nicht tiefer in den Mehrschichtverbundartikel eindringen kann als bis zur Oberfläche des Reflektorelements. Die gewünschte Eindringtiefe hängt daher nicht mehr so stark von der exakten Einstellung von Parametern wie der Bestrahlungsdauer und/oder der Laserleistung ab. In anderen Worten bildet das in dem Mehrschichtverbundartikel verbaute Reflektorelement eine Art passive Sperrschicht gegen das Abtragen mittels Laserstrahlung. Dadurch eignet sich das erfindungsgemäße Verfahren hervorragend dazu, zumindest teilweise automatisiert zu werden.

Ein weiterer Vorteil der Erfindung ist, dass die von dem Reflektorelement reflektierte Laserstrahlung detektiert und dazu genutzt werden kann, um den Bestrahlungsvorgang bzw. das Abtragen zu regeln. Denn die Detektion von reflektierter Laserstrahlung deutet darauf hin, dass die Deckschicht bis auf das Reflektorelement abgetragen und somit die gewünschte Abtragungstiefe erreicht ist und der Bestrahlungsvorgang beendet werden kann.

Das elastomere Material ist insbesondere ein Elastomer und/oder ein thermoplastisches Elastomer.

Der Mehrschichtverbundartikel ist insbesondere ein Schlauch, dessen Schichten sich im Wesentlichen rotationssymmetrisch um eine Längsmittelachse erstrecken, wobei die Trägerschicht einen Fluidkanal zur Führung eines Fluids umschließt. In diesem Fall kann die Trägerschicht als Innenschicht und/oder die Deckschicht als Außenschicht bezeichnet werden. In diesem Fall bilden die Trägerschicht und die Deckschicht jeweils einen im Wesentlichen zylindrischen Mantel aus. In diesem Fall ist eine Richtung "senkrecht zur Schichtebene" die radiale Richtung bezogen auf die Längsmittelachse.

Die Leiteranordnung kann eine gedruckte Elektronik sein, d.h. die Leiterbahnen können durch leitfähige Tinten auf ein insbesondere flexibles, dielektrisches Substrat ausgebildet sein. Die Funktionen der gedruckten Elektronik können dabei z.B. sensorischer, signalübertragender und/oder aktuatorischer Art sein. In anderen Worten kann die Leiteranordnung einen Sensor, eine Antenne und/oder einen Aktuator oder einen Teil davon ausbilden.

Für das Reflektorelement kommen grundsätzlich verschiedene Materialien in Betracht, sofern sie die Laserstrahlung in ausreichendem Maße reflektieren oder eine höhere Abtragsschwelle als das elastomere Grundmaterial haben, um den Abtragsprozess signifikant zu verzögern. In einigen Ausführungsformen kann das Material des Reflektorelements zumindest abschnittsweise elektrisch leitfähig sein. Hierzu können verschiedene anorganische Materialien (wie z.B. Metalle, Metalloxide, Keramiken, Metallfolien etc.) und organische Materialien (wie z.B. leitfähige Polymere, Farbstoffe etc.) verwendet werden, sofern sie einen ausreichend hohen Reflexionsgrad für die Laserstrahlung aufweisen. Leitfähige Materialien bieten unter anderem den Vorteil, dass sie von außen leicht mittels unterschiedlicher Sensoren aufgefunden werden können, was die Lokalisierung des in dem Mehrschichtverbundartikel integrierten Reflektorelements begünstigt. In einigen Ausführungsformen kann das Material des Reflektorelements zumindest abschnittsweise dielektrisch sein. Dies hat unter anderem den Vorteil, dass das Reflektorelement die elektromagnetischen Eigenschaften der Leiteranordnung nicht beeinträchtig. Daher könnten dielektrische Abschnitte des Reflektorelements sehr nah an der Leiteranordnung oder sogar auf der Leiteranordnung angeordnet werden. Hierzu können beispielsweise diverse Polymere in Betracht kommen, sofern sie einen ausreichend hohen Reflexionsgrad für die Laserstrahlung aufweisen. Bevorzugt ist das Material des Reflektorelements derart ausgebildet, dass es (z.B. als leitfähige Tinte) mittels Druckverfahren verarbeitbar ist. Vorzugsweise weist das Reflektorelement einen höheren Reflexionsgrad auf als die Deckschicht, insbesondere wobei der Reflexionsgrad des Reflektorelements zumindest um einen Faktor 3 höher ist als der Reflexionsgrad der Deckschicht. Das Reflektorelement kann in Form einer sich in der Schichtebene des Mehrschichtverbundartikels erstreckenden Bahn vorliegen, die einen Pfad vorgibt, entlang dem die Deckschicht durchtrennt werden kann. In anderen Worten kann der geometrische Verlauf einer solchen "Reflektorbahn" ein Bearbeitungspfad bzw. eine Schnittlinie vorgeben. Alternativ kann das Reflektorelement als Plättchen ausgebildet sein und somit einen flächigen Bereich bereitstellen, innerhalb dem die Deckschicht entlang eines beliebigen Pfades durchtrennt werden kann. Vorzugsweise weist das Reflektorelement zumindest einen leitfähigen Abschnitt und/oder zumindest einen dielektrischen bzw. nichtleitfähigen Abschnitt auf. Das Reflektorelement kann beispielsweise auch eine Metallfolie sein, die über oder unter der Schaltungsebene angeordnet ist.

Vorzugsweise beträgt die Dicke des Reflektorelements 1 nm bis 500 µm. Auf diese Weise wird der Aufbau gängiger Mehrschichtverbundartikel wie Schläuchen, Förderbändern, Riemen und/oder Luftfedern minimal beeinträchtigt. Besonders bevorzugt beträgt die Dicke des Reflektorelements 1 µm bis 100 µm, so dass das Reflektorelement mittels bewährter Druck- oder Laminations-Verfahren prozesssicher hergestellt werden kann. Die Dicke des Reflektorelements ist hierbei definiert als die quer zur Schichtebene gemessene Abmessung des Reflektorelements.

Vorzugsweise beträgt die Dicke der Trägerschicht 0,5 mm bis 50 mm, bevorzugt 1 mm bis 10 mm. Vorzugsweise beträgt die Dicke der Deckschicht 0,5 mm bis 50 mm, bevorzugt 1 mm bis 10 mm.

In einer bevorzugten Ausgestaltung des erfindungsgemäßen Verfahrens sind die Leiteranordnung und das Reflektorelement auf einer gemeinsamen Substratschicht angeordnet, insbesondere aufgedruckt. Auf diese Weise ist die Tiefe des Durchbruchs auf die Tiefe der Leiteranordnung abgestimmt, was das Freilegen des Kontaktierungsbereichs wesentlich vereinfacht. Ferner können Leiteranordnung und Reflektorelement in einer vorbestimmten Position und Lage zueinander in den Mehrschichtverbundartikel integriert werden.

In einer weiteren bevorzugten Ausgestaltung des erfindungsgemäßen Verfahrens ist das Reflektorelement von einer Leiterbahn der Leiteranordnung ausgebildet. Insbesondere bildet dabei die Leiterbahn zumindest einen Teil des Kontaktierungsbereichs aus. Auf diese Weise ist die Leiteranordnung unmittelbar nach dem Abtragen der Deckschicht freigelegt und kann elektrisch kontaktiert werden.

In einer weiteren bevorzugten Ausgestaltung des erfindungsgemäßen Verfahrens ist das Reflektorelement eine von der Leiteranordnung separate Struktur. Insbesondere ist das Reflektorelement zumindest galvanisch von der Leiteranordnung getrennt. Dies ermöglicht einen Durchbruch der Deckschicht, ohne dabei Teile der Leiteranordnung unmittelbar zu exponieren.

In einer weiteren bevorzugten Ausgestaltung des erfindungsgemäßen Verfahrens ist aus einer Perspektive senkrecht zur Schichtebene des Mehrschichtverbundartikels zumindest ein Abschnitt des Reflektorelements vom Kontaktierungsbereich der Leiteranordnung beabstandet ist. Dies ermöglicht einen Durchbruch der Deckschicht in einem Bereich, der von der Leiteranordnung beabstandet ist, was das Risiko von Beeinträchtigungen der Leiteranordnung durch Einwirkung von Laserstrahlen verringert.

In einer weiteren bevorzugten Ausgestaltung des erfindungsgemäßen Verfahrens aus einer Perspektive senkrecht zur Schichtebene des Mehrschichtverbundartikels zumindest ein Abschnitt des Reflektorelements den Kontaktierungsbereich von zumindest zwei Seiten umgibt. In anderen Worten wird mittels Laserablation um den Kontaktierungsbereich herum geschnitten. Auf diese Weise kann der Kontaktierungsbereich nach dem Abtragen der Deckschicht besser freigelegt werden. Der zumindest eine Abschnitt des Reflektorelements kann den Kontaktierungsbereich von drei Seiten umgeben, d.h. ein Schnitt im Wesentlichen u-förmig sein.

In einer weiteren bevorzugten Ausgestaltung des erfindungsgemäßen Verfahrens ist zumindest ein Abschnitt des Reflektorelements nicht elektrisch leitfähig ausgebildet. Dadurch kann das Reflektorelement unmittelbar an oder auf der Leiteranordnung angeordnet werden, ohne dass Leiterbahnen der Leiteranordnung kurzgeschlossen werden. Auf diese Weise wird die Flexibilität bei der Ausgestaltung der Schnittpfade erhöht. Bevorzugt ist der nicht elektrisch leitfähig ausgebildete Abschnitt des Reflektorelements zumindest eine Leiterbahn, bevorzugt zumindest zwei Leiterbahnen der Leiteranordnung berührend angeordnet.

In einer weiteren bevorzugten Ausgestaltung des erfindungsgemäßen Verfahrens weist das Verfahren folgenden Schritt auf:
- Freilegen des Kontaktierungsbereichs der Leiteranordnung.

In einer weiteren bevorzugten Ausgestaltung des erfindungsgemäßen Verfahrens weist das Verfahren folgenden Schritt auf:
- Elektrisches Kontaktieren des Kontaktierungsbereich der Leiteranordnung mit einer externen Komponente, insbesondere mit einem Kabel oder einem Stecker.

In einer weiteren bevorzugten Ausgestaltung des erfindungsgemäßen Verfahrens weist das Verfahren folgende Schritte auf:
- Detektieren, insbesondere mittels eines Sensors, zumindest eines Teils der in einem bestrahlten Bereich des Mehrschichtverbundartikels von dem Reflektorelement reflektierten Laserstrahlung und
- Steuern, insbesondere Beenden des Abtragens im bestrahlten Bereich in Abhängigkeit der detektierten reflektierten Laserstrahlung.

Gemäß dem bereits vor- sowie dem weiter unten nachbeschriebenen wird die eingangs gestellte Aufgabe auch durch ein Verfahren mit den Merkmalen des Anspruchs 13 gelöst.

Der erfindungsgemäße Mehrschichtverbundartikel, insbesondere ein Schlauch, ein Förderband, ein Riemen und/oder eine Luftfeder, enthält ein elastomeres Material sowie vorzugsweise einen Festigkeitsträger, wobei der Mehrschichtverbundartikel eine Trägerschicht und eine auf der Trägerschicht angeordnete Deckschicht aufweist, wobei in einem ersten Bereich des Mehrschichtverbundartikels zwischen einer der Deckschicht zugewandten Außenfläche der Trägerschicht und einer der Trägerschicht abgewandten Außenfläche der Deckschicht eine Leiteranordnung mit einem Kontaktierungsbereich angeordnet ist, wobei der Kontaktierungsbereich ausgebildet ist, mit einer externen Komponente elektrisch verbunden zu werden, wobei in einem zweiten Bereich des Mehrschichtverbundartikels zwischen der der Deckschicht zugewandten Außenfläche der Trägerschicht und der der Trägerschicht abgewandten Außenfläche der Deckschicht ein von der Leiteranordnung separates Reflektorelement angeordnet ist.

Auf diese Weise werden die für das Verfahren beschriebenen Vorteile auch in dem Mehrschichtverbundartikel realisiert. Sofern das Reflektorelement leitfähige Abschnitte aufweist, sind diese bevorzugt von der Leiteranordnung galvanisch getrennt.

In einer bevorzugten Ausgestaltung des erfindungsgemäßen Mehrschichtverbundartikels sind die Leiteranordnung und die Reflektorbahn auf einer gemeinsamen Substratschicht angeordnet, insbesondere aufgedruckt.

In einer weiteren bevorzugten Ausgestaltung des erfindungsgemäßen Mehrschichtverbundartikels ist aus einer Perspektive senkrecht zur Schichtebene des Mehrschichtverbundartikels zumindest ein Abschnitt der Reflektorbahn vom Kontaktierungsbereich der Leiteranordnung beabstandet.

In einer weiteren bevorzugten Ausgestaltung des erfindungsgemäßen Mehrschichtverbundartikels begrenzt aus einer Perspektive senkrecht zur Schichtebene des Mehrschichtverbundartikels das Reflektorelement den Kontaktierungsbereich von zumindest zwei Seiten, bevorzugt von zumindest drei Seiten.

In einer weiteren bevorzugten Ausgestaltung des erfindungsgemäßen Mehrschichtverbundartikels ist zumindest ein Abschnitt des Reflektorelements nicht elektrisch leitfähig ausgebildet. Vorzugsweise ist der nicht elektrisch leitfähig ausgebildete Abschnitt des Reflektorelements zumindest eine, bevorzugt zumindest zwei Leiterbahnen der Leiteranordnung berührend angeordnet.

In einer weiteren bevorzugten Ausgestaltung des erfindungsgemäßen Mehrschichtverbundartikels weist das Reflektorelement einen höheren Reflexionsgrad auf als die Deckschicht, insbesondere wobei der Reflexionsgrad der Reflektorbahn zumindest um einen Faktor 3 höher ist als der Reflexionsgrad der Deckschicht.

Es wird ausdrücklich darauf hingewiesen, dass die vorstehend erläuterten Ausgestaltungen der Erfindung jeweils für sich oder in einer beliebigen technisch sinnvollen Kombination auch untereinander jeweils mit dem Gegenstand der unabhängigen Ansprüche kombinierbar sind.

Abwandlungen und Ausgestaltungen der Erfindung sowie weitere Vorteile und Einzelheiten der Erfindung lassen sich der nachfolgenden gegenständlichen Beschreibung und den Zeichnungen entnehmen. In den schematischen Figuren zeigen:
- Fig. 1a: ein erstes Ausführungsbeispiel eines erfindungsgemäßen Mehrschichtverbundartikels in einer Draufsicht;
- Fig. 1b: das erste Ausführungsbeispiel in einer Schnittdarstellung gemäß Linie A-A aus Fig. 1a;
- Fig. 2a: das erste Ausführungsbeispiel nach dem Abtragen der Deckschicht in einer Draufsicht;
- Fig. 2b: das erste Ausführungsbeispiel nach dem Abtragen der Deckschicht in einer Schnittdarstellung gemäß Linie A-A aus Fig. 2a;
- Fig. 3a: das erste Ausführungsbeispiel nach dem Freilegen des Kontaktierungsbereichs in einer Draufsicht;
- Fig. 3b: das erste Ausführungsbeispiel nach dem Freilegen des Kontaktierungsbereichs in einer Schnittdarstellung gemäß Linie A-A aus Fig. 3a;
- Fig. 4a: ein zweites Ausführungsbeispiel eines erfindungsgemäßen Mehrschichtverbundartikels in einer Draufsicht;
- Fig. 4b: das zweite Ausführungsbeispiel in einer Schnittdarstellung gemäß Linie A-A aus Fig. 1;
- Fig. 5: ein drittes Ausführungsbeispiel eines erfindungsgemäßen Mehrschichtverbundartikels in Form eines Schlauches in einer Schnittdarstellung; und
- Fig. 6: ein Ablaufschema eines Ausführungsbeispiels eines erfindungsgemäßen Verfahrens.

Gleich oder ähnlich wirkende Teile sind - sofern dienlich - mit identischen Bezugsziffern versehen.

Einzelne technische Merkmale der nachbeschriebenen Ausführungsbeispiele können auch in Kombination mit vorbeschriebenen Ausführungsbeispielen sowie den Merkmalen der unabhängigen Ansprüche und etwaiger weiterer Ansprüche zu erfindungsgemäßen Gegenständen kombiniert werden.

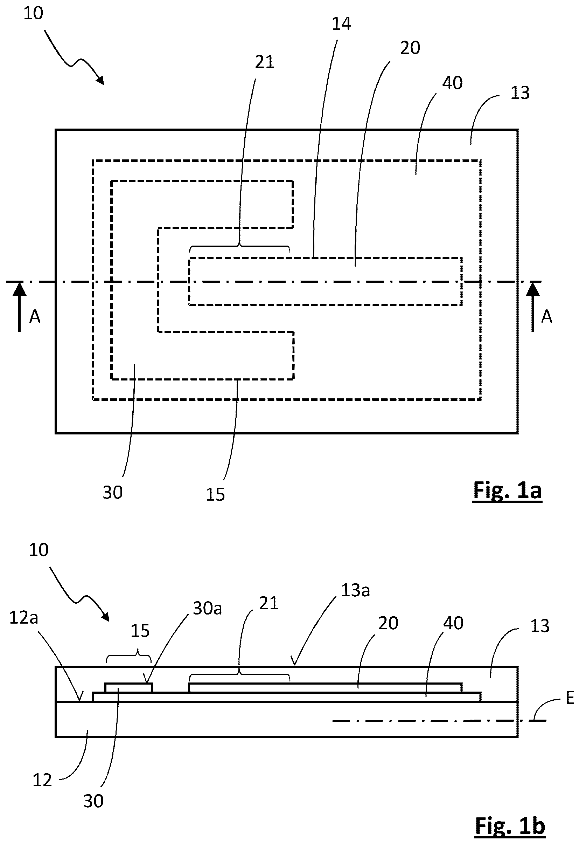

Figuren 1a bis 5 zeigen verschiedene Ausführungsbeispiele eines erfindungsgemäßen Mehrschichtverbundartikels 10, in denen eine elektrische Kontaktierungsmöglichkeit für eine in dem Mehrschichtverbundartikel 10 integrierte Leiteranordnung 20 bereitgestellt wird. Die Leiteranordnung 20 kann eine gedruckte Elektronik sein. Die Leiteranordnung 20 kann beispielsweise einen Sensor, eine Antenne und/oder einen Aktuator oder einen Teil davon ausbilden.

Der Mehrschichtverbundartikel 10 enthält ein elastomeres Material sowie vorzugsweise einen Festigkeitsträger. Der Mehrschichtverbundartikel 10 weist eine Trägerschicht 12 und eine auf der Trägerschicht 12 angeordnete Deckschicht 13 auf. Als Mehrschichtverbundartikel 10 kommt insbesondere ein Schlauch, ein Förderband, ein Riemen und/oder eine Luftfeder in Betracht. Ist der Mehrschichtverbundartikel 10 ein Schlauch, kann die Trägerschicht 12 auch als Innenschicht und die Deckschicht 13 auch als Außenschicht bezeichnet werden.

Die Leiteranordnung 20 ist in einem ersten Bereich 14 des Mehrschichtverbundartikels 10 zwischen einer der Deckschicht 13 zugewandten Außenfläche 12a der Trägerschicht 12 und einer der Trägerschicht 12 abgewandten Außenfläche 13a der Deckschicht 13 angeordnet. Die Leiteranordnung 20 weist einen Kontaktierungsbereich 21 auf, der ausgebildet ist, zum Zwecke der Signalübertragung und/oder zum Zwecke der Energieversorgung mit einer externen Komponente - wie z.B. einem Kabel oder einem Stecker - eine elektrische Verbindung einzugehen. Dieser von der Deckschicht 13 bedeckte Kontaktierungsbereich 21 soll prozesssicher und möglichst wenig invasiv freigelegt werden, insbesondere ohne dabei die Leiteranordnung oder die Trägerschicht 12 zu beschädigen.

Um dies zu gewährleisten, ist in einem zweiten Bereich 15 des Mehrschichtverbundartikels 10 zwischen der Außenfläche 12a der Trägerschicht 12 und der Außenfläche 13a der Deckschicht 13 ein Reflektorelement 30 angeordnet. Durch die Positionierung des Reflektorelements 30 kann die Deckschicht 12 im zweiten Bereich 15 mittels Laserablation von der der Trägerschicht 12 abgewandten Außenfläche 13a der Deckschicht 13 zumindest bis zu einer der Trägerschicht 12 abgewandten Außenfläche 30a des Reflektorelements 30 prozesssicher abgetragen werden. Hierzu kann gepulste Laserstrahlung mit hoher Leistungsdichte auf den zweiten Bereich 15 beispielsweise in einem Winkel von 90 Grad zur Außenfläche 13a der Deckschicht 13 bzw. zu einer Schichtebene E fokussiert werden. Das insbesondere ein Elastomer und/oder ein thermoplastisches Elastomer enthaltende Material der Decksicht 13 absorbiert die Laserstrahlung und wird auf diese Weise sublimiert und abgetragen. Die Deckschicht 13 kann beispielsweise eine schwarze Gummischicht sein. Das Abtragen der Deckschicht 13 im zweiten Bereich 15 erfolgt so lange, bis das Reflektorelement 30 freigelegt wird. Trifft die Laserstrahlung auf das Reflektorelement 30, wird diese von der Außenfläche 30a des Reflektorelements 30 reflektiert, so dass das Material des Reflektorelements 30 nicht oder nur in geringem Maße abgetragen wird. Das Material des Reflektorelements 30 kann beispielsweise ein Metall oder eine Metalllegierung oder aber auch ein anderes reflektierendes Material sein. Das Reflektorelement 30 schirmt die unter ihm liegenden Strukturen gegenüber der Laserstrahlung ab, wodurch diese nicht beschädigt oder abgetragen werden. Dies ermöglicht ein kontrolliertes Abtragen bzw. Durchbrechen der Deckschicht 13 und vereinfacht das Freilegen des Kontaktierungsbereichs 21. Die Außenfläche 30a des Reflektorelements 30 bildet in allen gezeigten Ausführungsbeispielen eine Grenzfläche zur Deckschicht 13.

Die Leiteranordnung 20 und das Reflektorelement 30 sind auf einer gemeinsamen Substratschicht 40 angeordnet, insbesondere dort aufgedruckt. Auf diese Weise kann das Reflektorelement 30 in einfacher Weise zusammen mit der Leiteranordnung 20 in den Mehrschichverbundartikel 10 integriert werden. Im vorliegenden Fall sind die Leiteranordnung 20 und das Reflektorelement 30 auf derselben Seite der Substratschicht 40 angeordnet. Ersichtlich können die Leiteranordnung 20 und das Reflektorelement 30 auch auf unterschiedlichen Seiten der Substratschicht 40 angeordnet sein. Das Reflektorelement 30 erstreckt sich hierbei bahnförmig parallel zur Schichtebene E.

Die Figuren 1a bis 3b zeigen ein erstes Ausführungsbeispiel eines erfindungsgemäßen Mehrschichtverbundartikels 10. Hierbei ist das Reflektorelement 30 eine von der Leiteranordnung 20 separate und zumindest galvanisch getrennte Struktur. In diesem Fall kann das Reflektorelement 30 aus demselben Material ausgebildet sein wie die Leiteranordnung 20, was den Fertigungsaufwand verringert. Aus einer Perspektive senkrecht zur Schichtebene E des Mehrschichtverbundartikels 10 (siehe Fig. 1a, 2a und 3a) ist zumindest ein Abschnitt des Reflektorelements 40 vom Kontaktierungsbereich 21 der Leiteranordnung 20 beabstandet. Ferner wird aus dieser Perspektive der Kontaktierungsbereich 21 von dem Reflektorelement 30 von drei Seiten begrenzt. In anderen Worten erstreckt sich das Reflektorelement 30 sich bogenförmig bzw. u-förmig um den Kontaktierungsbereich 21.

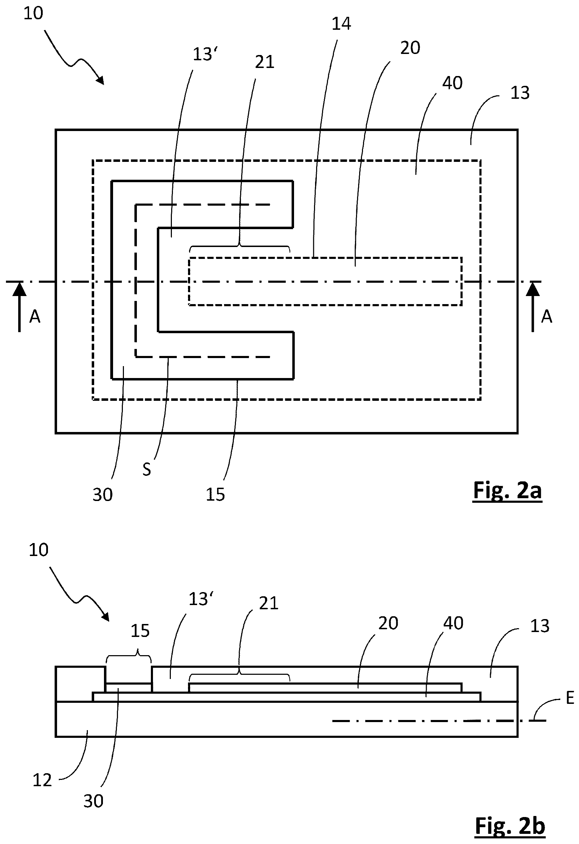

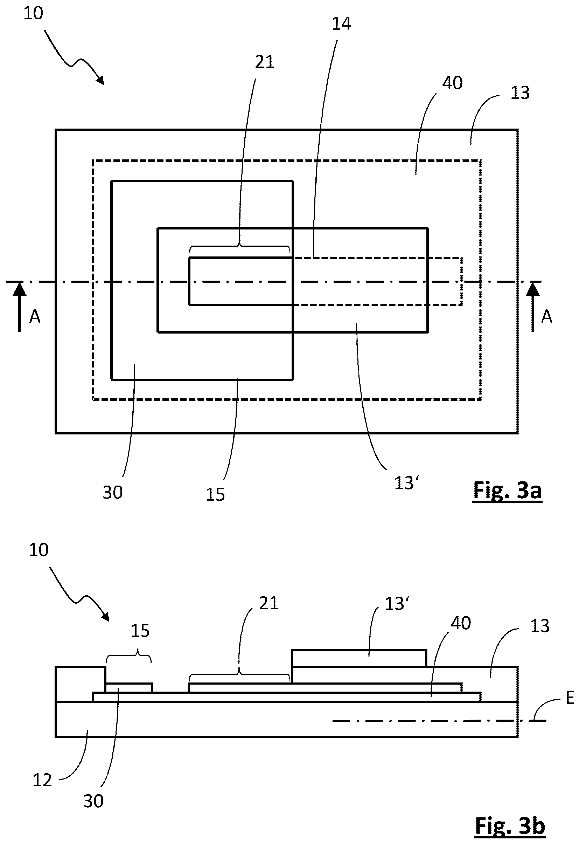

Die Figuren 2a und 2b zeigen das erste Ausführungsbeispiel, nachdem die Deckschicht 13 im zweiten Bereich 15 abgetragen wurde. In anderen Worten wurde der fokussierte Laserstrahl entlang eines durch den geometrischen Verlauf des Reflektorelements 30 vorgegebenen Bearbeitungspfad S geführt, wobei die Deckschicht 13 entlang des Bearbeitungspfades S abgetragen wurde. In dem zweiten Bereich 15 ist auf diese Weise ein u-förmiger Durchbruch bzw. Schnitt entstanden, der den Kontaktierungsbereich 21 und einen laschenartigen Abschnitt 13' der Deckschicht 13 von drei Seiten umgibt. Dieser laschenartige Abschnitt 13' kann beispielsweise, wie in den Figuren 3a und 3b gezeigt, umgeklappt werden, um den Kontaktierungsbereich 21 freizulegen. Anschließend kann der Kontaktierungsbereich 21 mit der externen Komponente elektrisch verbunden werden.

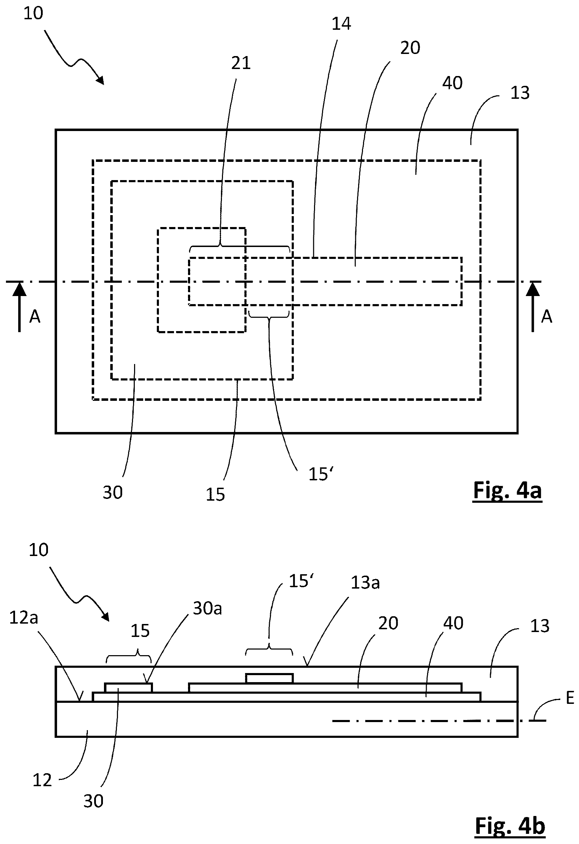

Die Figuren 4a und 4b zeigen ein zweites Ausführungsbeispiel eines erfindungsgemäßen Mehrschichtverbundartikels 10, das sich vom ersten Ausführungsbeispiel nur durch den geometrischen Verlauf des Reflektorelements 30 unterscheidet. Aus einer Perspektive senkrecht zur Schichtebene E (siehe Fig. 4a) wird der Kontaktierungsbereich 21 von dem Reflektorelement 30 von vier Seiten begrenzt. In anderen Worten erstreckt sich das Reflektorelement 30 sich umlaufend um den Kontaktierungsbereich 21. Ein Abschnitt 15' des Reflektorelements 30, das unmittelbar auf der Leiteranordnung 20 angeordnet ist, ist nicht elektrisch leitfähig ausgebildet, um die elektromagnetischen Eigenschaften der Leiteranordnung 20 nicht zu beeinträchtigen. Dies ist vor allem dann erforderlich, wenn mehr als eine Leiterbahn der Leiteranordnung 20 von dem Reflektorelement 30 gekreuzt werden (nicht gezeigt). Die übrigen Abschnitte des Reflektorelements 30 können leitfähig ausgebildet sein, auch um eine Detektion von außen mittels geeigneter Sensoren zu ermöglichen. In anderen Worten können je nach Anwendungsfall verschiedene Abschnitte des Reflektorelements 30 aus verschiedenen Materialien gefertigt sein. Nachdem die Deckschicht 13 in dem zweiten Bereich 15 abgetragen wurde (nicht gezeigt), entsteht ein umlaufender Durchbruch, in dessen Mitte ein restlicher Teil der Deckschicht 13 verbleibt. Dieser kann daraufhin in einfacher Weise zum Freilegen des Kontaktierungsbereichs 21 entfernt werden. Anschließend kann der Kontaktierungsbereich 21 mit der externen Komponente elektrisch verbunden werden.

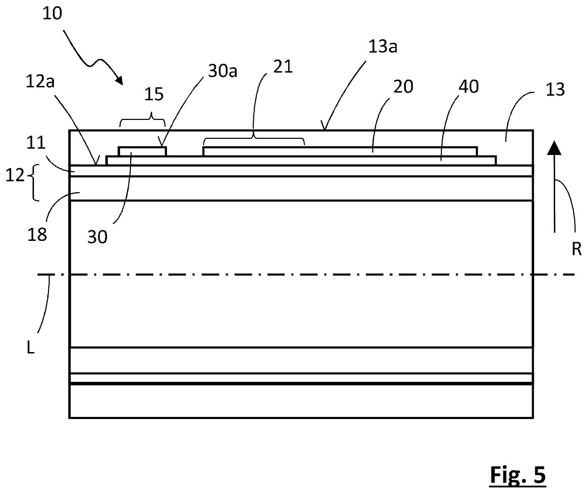

Fig. 5 zeigt ein drittes Ausführungsbeispiel mit einem als Schlauch ausgebildeten Mehrschichtverbundartikel 10. Die Schichten 12, 13 verlaufen im Wesentlichen rotationssymmetrisch um eine Längsmittelachse L. Eine Höhe bzw. Dicke einer Schicht wird in diesem Fall in radialer Richtung R gemessen. Die Trägerschicht 12 kann in diesem Fall auch als Innenschicht bezeichnet werden. Die Deckschicht 13 kann in diesem Fall auch als Außenschicht bezeichnet werden. Die Trägerschicht 12 weist eine innerste Schicht 18 auf, die einen Fluidkanal definiert. Die Trägerschicht 12 weist ferner einen metallischen oder textilen Festigkeitsträger 11 auf. Die Integrität des Schlauches wird in erster Linie durch die Trägerschicht 12 sichergestellt, weshalb diese bei der Herstellung der elektrischen Kontaktierungsmöglichkeit nicht beschädigt werden darf. Mit dem erfindungsgemäßen Verfahren kann die Deckschicht 13 zur Freilegung des Kontaktierungsbereichs 21 in einer Weise durchbrochen werden, bei der Beschädigungen der Trägerschicht 12 vermieden werden können. Beispielsweise kann die Deckschicht 13 analog zum ersten oder zweiten Ausführungsbeispiel abgetragen werden.

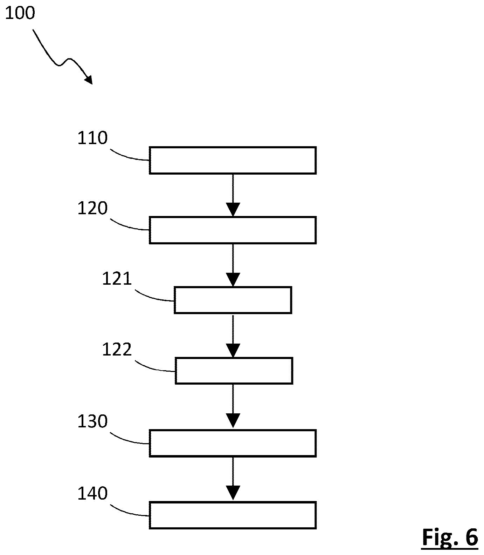

Fig. 6 zeigt ein Ablaufschema eines Ausführungsbeispiels eines erfindungsgemäßen Verfahrens 100 zur Herstellung eines Mehrschichtverbundartikels 10 mit darin integrierter Leiteranordnung 20, aufweisend folgende Schritte:
- Bereitstellen 110 eines Mehrschichtverbundartikels 10, insbesondere eines Schlauches, eines Förderbands, eines Riemens und/oder einer Luftfeder, enthaltend ein elastomeres Material sowie vorzugsweise einen Festigkeitsträger, wobei der Mehrschichtverbundartikel 10 eine Trägerschicht 12 und eine auf der Trägerschicht 12 angeordnete Deckschicht 13 aufweist,
   wobei in einem ersten Bereich 14 des Mehrschichtverbundartikels 10 zwischen einer der Deckschicht 13 zugewandten Außenfläche 12a der Trägerschicht 12 und einer der Trägerschicht 12 abgewandten Außenfläche 13a der Deckschicht 13 eine Leiteranordnung 20 mit einem Kontaktierungsbereich 21 angeordnet ist, wobei der Kontaktierungsbereich 21 ausgebildet ist, mit einer externen Komponente elektrisch verbunden zu werden,
   wobei in einem zweiten Bereich 15 des Mehrschichtverbundartikels 10 zwischen der Außenfläche 12a der Trägerschicht 12 und der Außenfläche 13a der Deckschicht 13 ein Reflektorelement 30 angeordnet ist; und
- Abtragen 120 der Deckschicht 13 im zweiten Bereich 15 mittels Laserablation von der Außenfläche 13a der Deckschicht 13 zumindest bis zu einer der Trägerschicht 12 abgewandten Außenfläche 30a des Reflektorelements 30.

In einigen Ausführungsbeispielen kann das Verfahren aufweisen:
- Freilegen 130 des Kontaktierungsbereichs 21 der Leiteranordnung 20.

In einigen Ausführungsbeispielen kann das Verfahren aufweisen:
- Elektrisches Kontaktieren 140 des Kontaktierungsbereichs 21 der Leiteranordnung 20 mit einer externen Komponente, insbesondere mit einem Kabel oder einem Stecker.

In einigen Ausführungsbeispielen kann das Verfahren aufweisen:
- Detektieren 121, insbesondere mittels eines Sensors, zumindest eines Teils der in einem bestrahlten Bereich des Mehrschichtverbundartikels 10 von dem Reflektorelement 40 reflektierten Laserstrahlung und
- Steuern, insbesondere Beenden 122 des Abtragens 120 im bestrahlten Bereich in Abhängikeit der detektierten reflektierten Laserstrahlung.

Ergänzend sei darauf hingewiesen, dass "aufweisend" keine anderen Elemente oder Schritte ausschließt und "ein" oder "eine" keine Vielzahl ausschließt.

Der Schutzbereich der vorliegenden Erfindung ist durch die Patentansprüche gegeben und wird durch die in der Beschreibung erläuterten oder den Figuren gezeigten Merkmale nicht beschränkt.

## Patentansprüche

1. Verfahren (100) zur Herstellung eines Mehrschichtverbundartikels (10) mit einer darin integrierten Leiteranordnung (20), aufweisend folgende Schritte:
- Bereitstellen (110) eines Mehrschichtverbundartikels (10), insbesondere eines Schlauches, eines Förderbands, eines Riemens und/oder einer Luftfeder, enthaltend ein elastomeres Material sowie vorzugsweise einen Festigkeitsträger, wobei der Mehrschichtverbundartikel (10) eine Trägerschicht (12) und eine auf der Trägerschicht (12) angeordnete Deckschicht (13) aufweist,
wobei in einem ersten Bereich (14) des Mehrschichtverbundartikels (10) zwischen einer der Deckschicht (13) zugewandten Außenfläche (12a) der Trägerschicht (12) und einer der Trägerschicht (12) abgewandten Außenfläche (13a) der Deckschicht (13) eine Leiteranordnung (20) mit einem Kontaktierungsbereich (21) angeordnet ist, wobei der Kontaktierungsbereich (21) ausgebildet ist, mit einer externen Komponente elektrisch verbunden zu werden,
wobei in einem zweiten Bereich (15) des Mehrschichtverbundartikels (10) zwischen der Außenfläche (12a) der Trägerschicht (12) und der Außenfläche (13a) der Deckschicht (13) ein Reflektorelement (30) angeordnet ist; und
- Abtragen (120) der Deckschicht (13) im zweiten Bereich (15) mittels Laserablation von der Außenfläche (13a) der Deckschicht (13) zumindest bis zu einer der Trägerschicht (12) abgewandten Außenfläche (30a) des Reflektorelements (30).

2. Verfahren (100) nach Anspruch 1, wobei die Leiteranordnung (20) und das Reflektorelement (30) auf einer gemeinsamen Substratschicht (40) angeordnet, insbesondere aufgedruckt sind.

3. Verfahren (100) nach Anspruch 1 oder 2, wobei das Reflektorelement (30) von einer Leiterbahn der Leiteranordnung (20) ausgebildet ist.

4. Verfahren (100) nach Anspruch 1 oder 2, wobei das Reflektorelement (30) eine von der Leiteranordnung (20) separate Struktur ist.

5. Verfahren (100) nach einem der vorangehenden Ansprüche, wobei aus einer Perspektive senkrecht zur Schichtebene (E) des Mehrschichtverbundartikels (10) zumindest ein Abschnitt des Reflektorelements (30) vom Kontaktierungsbereich (21) der Leiteranordnung (20) beabstandet ist.

6. Verfahren (100) nach einem der vorangehenden Ansprüche, wobei aus einer Perspektive senkrecht zur Schichtebene (E) des Mehrschichtverbundartikels (10) zumindest ein Abschnitt des Reflektorelements (30) den Kontaktierungsbereich (21) von zumindest zwei Seiten umgibt.

7. Verfahren (100) nach einem der vorangehenden Ansprüche, wobei zumindest ein Abschnitt (15') des Reflektorelements (30) nicht elektrisch leitfähig ausgebildet ist.

8. Verfahren (100) nach Anspruch 7, wobei der nicht elektrisch leitfähig ausgebildete Abschnitt (15') des Reflektorelements (30) zumindest eine Leiterbahn, bevorzugt zumindest zwei Leiterbahnen der Leiteranordnung (20) berührend angeordnet ist.

9. Verfahren (100) nach einem der vorangehenden Ansprüche, wobei das Reflektorelement (30) einen höheren Reflexionsgrad aufweist als die Deckschicht (13), insbesondere wobei der Reflexionsgrad des Reflektorelements (30) zumindest um einen Faktor 3 höher ist als der Reflexionsgrad der Deckschicht (13).

10. Verfahren (100) nach einem der vorangehenden Ansprüche, aufweisend folgenden Schritt:
- Freilegen (130) des Kontaktierungsbereichs (21) der Leiteranordnung (20).

11. Verfahren (100) nach einem der vorangehenden Ansprüche, aufweisend folgenden Schritt:
- Elektrisches Kontaktieren (140) des Kontaktierungsbereichs (21) der Leiteranordnung (20) mit einer externen Komponente, insbesondere mit einem Kabel oder einem Stecker.

12. Verfahren (100) nach einem der vorangehenden Ansprüche, aufweisend folgenden Schritt:
- Detektieren (121), insbesondere mittels eines Sensors, zumindest eines Teils der in einem bestrahlten Bereich des Mehrschichtverbundartikels (10) von dem Reflektorelement (40) reflektierten Laserstrahlung und
- Steuern, insbesondere Beenden (122) des Abtragens (120) im bestrahlten Bereich in Abhängigkeit der detektierten reflektierten Laserstrahlung.

13. Mehrschichtverbundartikel (10), insbesondere ein Schlauch, ein Förderband, ein Riemen und/oder eine Luftfeder, enthaltend ein elastomeres Material sowie vorzugsweise einen Festigkeitsträger,
wobei der Mehrschichtverbundartikel (10) eine Trägerschicht (12) und eine auf der Trägerschicht (12) angeordnete Deckschicht (13) aufweist,
wobei in einem ersten Bereich (14) des Mehrschichtverbundartikels (10) zwischen einer der Deckschicht (13) zugewandten Außenfläche (12a) der Trägerschicht (12) und einer der Trägerschicht (12) abgewandten Außenfläche (13a) und der Deckschicht (13) eine Leiteranordnung (20) mit einem Kontaktierungsbereich (21) angeordnet ist, wobei der Kontaktierungsbereich (21) ausgebildet ist, mit einer externen Komponente elektrisch verbunden zu werden, wobei in einem zweiten Bereich (15) des Mehrschichtverbundartikels (10) zwischen der Außenfläche (12a) der Trägerschicht (12) und der Außenfläche (13a) der Deckschicht (13) ein Reflektorelement (30) angeordnet ist.

14. Mehrschichtverbundartikel (10) nach Anspruch 13 mit mindestens einem zusätzlichen Merkmal eines Mehrschichtverbundartikels (10) nach einem der Ansprüche 1 bis 12.
